# EUROPÄISCHE PATENTSCHRIFT

(11) **EP 0 663 023 B1**
(45) Veröffentlichungstag und Bekanntmachung des Hinweises auf die Patenterteilung: **06.08.1997**
(21) Anmeldenummer: 93921790.7
(22) Anmeldetag: 01.10.1993
(51) Int. Cl.: C30B 25/02, C30B 25/10, C23C 16/02, C23C 16/26, H01C 7/04, G01L 9/00, H01L 21/00

(54) **HETEROEPITAKTISCH ABGESCHIEDENES DIAMANT**
HETEROEPITAXIALLY DEPOSITED DIAMOND
DIAMANT DEPOSE PAR HETEROEPITAXIE

(30) Priorität: 01.10.1992 DE 4233085
(43) Veröffentlichungstag der Anmeldung: 19.07.1995
(73) Patentinhaber: FRAUNHOFER-GESELLSCHAFT ZUR FÖRDERUNG DER ANGEWANDTEN FORSCHUNG E.V., 80636 München (DE); DAIMLER-BENZ AKTIENGESELLSCHAFT, 70567 Stuttgart (DE)
(72) Erfinder: KLAGES, Claus-Peter, D-22085 Hamburg (DE); JIANG, Xin, D-25421 Pinneberg (DE); FÜSSER, Hans-Jürgen, D-89547 Gerstetten-Dettingen (DE); HARTWEG, Martin, D-89155 Erbach (DE); ZACHAI, Reinhard, D-89312 Günzburg (DE); RÖSLER, Manfred, D-89075 Ulm (DE)
(74) Vertreter: Pfenning, Meinig & Partner
(86) Internationale Anmeldenummer: DE9300936
(87) Internationale Veröffentlichungsnummer: WO9408076

(56) Entgegenhaltungen:
- EP-A- 0 286 310
- US-A- 4 870 030
- APPLIED PHYSICS LETTERS Bd. 60, Nr. 6 , 10. Februar 1992 , USA Seiten 698 - 700 XP298781 B.R.STONER ET AL 'TEXTURED DIAMOND GROWTH ON (100) B-SIC VIA MICROWAVE PLASMA CHEMICAL VAPOR DEPOSITION' in der Anmeldung erwähnt
- PHYSICA STATUS SOLIDI (A) Bd. 128, Nr. 2 , 16. Dezember 1991 , BERLIN DE Seiten K83 - K87 W.WANG ET AL 'HIGH RATE EPITAXIAL GROWTH OF DIAMOND ON SILICON (100) BY DC PLASMA CVD'
- PROCEEDINGS OF THE IEEE Bd. 79, Nr. 5 , Mai 1991 , N.Y,U.S Seiten 621 - 646 XP240229 W. ZUH 'GROWTH AND CHARACTERIZATION OF DIAMOND FILMS ON NONDIAMOND SUBSTRATES FOR ELECTRONIC APPLICATIONS'
- PATENT ABSTRACTS OF JAPAN vol. 15, no. 405 (E-1122)16. Oktober 1991 & JP,A,03 165 064 (IDEMITSU PETROCHEM CO LTD) 17. Juli 1991
- APPLIED PHYSICS LETTERS Bd. 60, Nr. 23 , 8. Juni 1992 , US Seiten 2923 - 2925 XP269803 M. ASLAM ET AL 'PIEZORESISTIVITY IN VAPOR-DEPOSITED DIAMOND FILMS'

## Beschreibung

Die Erfindung betrifft ein Verfahren zur Herstellung von heteroepitaktischen Diamantschichten aus der Gasphase auf Siliciumsubstrat sowie die mit diesem Verfahren hergestellte Schichten und deren Verwendung.

Wie aus M. W. Geis et al., IEEE Electron Device Letters EDL-8 (1987) 341, und M. W. Geis et al, J. Vac. Sci. Technol. A 6 (1988) 1953, bekannt, ist Diamant aufgrund seiner hervorragenden physikalischen Eigenschaften wie
- Bandlücke 5.5 eV
- Löcherbeweglichkeit 1800 cm²/Vₛ
- Elektronenbeweglichkeit 2000 cm²/Vₛ
- Elektronen-Sättigungsdriftgeschwindigkeit 2 x 10⁷ cm/s
- Durchbruchfeldstärke 1 x 10⁷ V/cm
- Thermische Leitfähigkeit 20 W/cmK
- Dielektrizitätszahl 5.7
ein hervorragender Werkstoff, der prinzipiell für Hochtemperatur-, Hochfrequenz- und Hochleistungs-Halbleiterbauelemente geeignet ist.

Seit japanische Wissenschaftler Anfang der 80er Jahre beschrieben haben, daß sich Diamant aus gasförmigen Substanzen als Schicht synthetisieren läßt, gab es weltweit vielfältige Bemühungen, neue Anwendungen für dieses zukunftsträchtige Material mit seinem großen technologischen Potential zu erschließen.

Die Bemühungen, CVD-Diamant als aktives bzw. passives Elektronikmaterial einzusetzen, sind jedoch bisher daran gescheitert, daß es noch nicht gelungen ist, aus dem gängigsten Substrat, nämlich Silicium, Diamant heteroepitaktisch abzuscheiden. Die Epitaxie ist aber die Voraussetzung, um elektrische Eigenschaften zu erreichen, wie sie von diesen Schichten erwartet werden. Um neue Lösungsansätze für dieses Problemfeld zu entwickeln und zu untersuchen, wurden zahlreiche Entwicklungen in der Vergangenheit durchgeführt. Auf Siliciumsubstraten wurde nur lokalisiertes epitaktisches Wachstum erreicht (D. G. Jeng, H. S. Tuan, R. F. Salat, und G. J. Fricano, Appl. Phys. Lett. 56, 1968 (1990); J. Narayan, A. R. Srivatra, M. Peters, S Yokota, und K. V. Ravi, Appl. Phys. Lett. 53, 1823, (1988)). Auf C-BN ist zwar die Heteroepitaxie erfolgreich, aber nur auf Partikeln, da es zur Zeit nicht möglich ist, ein kristallin großflächiges C-BN herzustellen (S. Koizumi, T. Murakami und T. Inuzuka, und K. Suzuki, Appl. Phys. Lett. 57, 563 (1990)). Auf Siliciumcarbit (1-Wafer), ein sehr aufwendig herstellbares Trägermaterial, ist nur teilweise orientiertes Wachstum des Diamantes (50 % der aufgewachsenen Kristalle) mit Bias-Nukleation durchgeführt worden (B. R. Stoner und J. T. Glass, Appl. Phys. Lett. 60, 698 (1992)).

Zu jüngster Zeit sind weitere Publikationen erschienen, die sich mit dieser Problematik beschäftigen.

Im Physical Review B V. 45, No 19, S 11067 ff, berichten Stoner et al. über die Abscheidung von Diamant auf Si. Dabei wird so vorgegangen, daß ein zweistufiger Prozeß vorgeschlagen wird, wobei eine Vorbehandlung (Keimbildung) unter Anlegung einer negativen Bias-Spannung bei einem 2 % Methan/Wasserstoffplasma erfolgt. Darauf folgt eine Wachstumsphase unter Beibehaltung der Bias-Spannung. Die Kristallite in den erhaltenen Schichten sind willkürlich orientiert.

Die Arbeitsgruppe von Yugo et al. (Appl. Phys. Lett. **58** (10) S 1036 ff) schlägt ebenfalls einen zweistufigen Prozeß vor. Die erste Stufe wird unter Anlegung einer negativen Bias-Spannung bei einem CH₄/H₂-Plasma durchgeführt, wobei der Methananteil bei 40 % liegt. Die Diamantabscheidung wird unter "normalen" Bedingungen (ca. 0,5iges Methan in H₂) ohne Bias durchgeführt. Aber auch dieses Verfahren führt zu keinen heteroepitaktischen Schichten, sondern ebenfalls zu willkürlich orientierten polykristallinen Schichten.

Die Europäische Patentanmeldung EP-A-0 268 310 (Crystallume) beschreibt ein Wirbelbettverfahren zur epitaktischen Abscheidung von synthetischen Diamantschichten auf Substraten. Beim Wirbelbettverfahren können prozeßbedingt jedoch nur kleine und kleinste, als "Keimpartikel" bezeichnete Substratkörnchen beschichtet werden, da die Substrate in "ständiger Fließbewegung" gehalten werden müssen (Spalte 4, Zeile 14 und Spalte 3, Zeile 40f). Dieser Sachverhalt schließt die Abscheidung von Diamantschichten auf flächigen Substraten, wie beispielsweise handelsüblichen Silizium-Wafern, aus.

Ein Verfahren, das es ermöglicht, auf dem gängigsten Substrat, nämlich Si, Diamant heteroepitaktisch und flächig abzuscheiden, ist demnach nicht bekannt.

Hier setzt die vorliegende Erfindung ein, deren Aufgabe es ist, ein Verfahren zur Herstellung von heteroepitaktischen Diamantschichten auf Siliciumsubstraten bereitzustellen.

Die Aufgabe wird hinsichtlich des Verfahrens durch die kennzeichnenden Merkmale des Anspruches 1 gelöst, in bezug auf die Schichten durch die Merkmale des Anspruches 11. Die Unteransprüche geben vorteilhafte Weiterbildungen an.

Da Silicium im Gegensatz zu Diamant sehr unterschiedliche Gitterparameter und eine niedrigere Oberflächenenergie aufweist, ist es nicht möglich, unter normalen Bedingungen eine hohe Keimdichte auf nicht vorbehandeltem Silicium zu bilden und dadurch eine Diamantabscheidung zu erreichen.

Überraschenderweise - und aufgrund der bisherigen Ergebnisse nicht zu erwarten - wurde gefunden, daß durch gezielte Vorbehandlung des Si-Substrates eine ausgezeichnet orientierte Diamant-Keimbildung ohne mechanische Diamantvorbekeimung erreicht wird.

Erfindungsgemäß wird ein dreistufiger Prozeß vorgeschlagen.

Im ersten Schritt erfolgt eine Vorbehandlung der Si-Oberfläche.

Bevorzugt wird dabei so vorgegangen, daß entweder eine Reinigung im Ultra-Hochvakuum bei < 10⁻⁹ mbar durchgeführt, wobei eine Substrattemperatur von > 950°C erforderlich ist, oder es wird eine Plasmareinigung mit H₂ mit oder ohne Bias-Spannung vorgenommen. Anschließend erfolgen die Keimbildung und das Diamantwachstum.

Es hat sich als wichtig herausgestellt, daß vor der Keimbildungsphase diese Vorbehandlung durchgeführt wird, um Verunreinigungen, insbesondere Oxide und/oder Sauerstoffverbindungen, von der Si-Oberfläche zu entfernen. Dies wird nach der ersten Variante (Hochvakuum) offenbar durch eine Desoirption der Verunreinigung erreicht und bei der zweiten Variante durch die H₂-Plasmabehandlung.

Es hat sich dabei herausgestellt, daß bereits zeitlich sehr kurze Vorbehandlungen (einige Sekunden) ausreichend sein können.

Vorteilhaft ist es, wenn die Vorbehandlung (Reinigung der Si-Oberfläche) im Falle der Plasmabehandlung mit einem nahezu 100% H₂-Plasma bei 300 bis 1100°C erfolgt. Bei Anlegung einer Bias-Spannung ist bevorzugt bei +50 bis -300 Volt zu arbeiten, besonders bevorzugt sind -50 Volt.

Im Falle der Plasmavorbehandlung ist es ausreichend, wenn zuerst ein reines H₂-Plasma gezündet wird und sofort anschließend (d.h. nach wenigen Sekunden) die Keimbildungsphase durchgeführt wird.

Besonders vorteilhaft ist es beim erfindungsgemäßen Verfahren, wenn bei der Plasmareinigung ebenfalls eine negative Bias-Spannung am Substrat angelegt wird. Diese Ausgestaltung der Erfindung begünstigt weiter die nachfolgende Keimbildung.

Das erfindungsgemäße Verfahren kann mit allen gängigen Prozeßgasen durchgeführt werden. Als Prozeßgase können eingesetzt werden: CO + CH₄, C₂H₅OH, Acetylen und Aceton oder z.B. CF₄ und Methan. Eine besonders bevorzugte Ausführungsform der Erfindung sieht Methan und Wasserstoff als Prozeßgas vor.

Im Falle von CH₄/H₂ hat es sich weiter als günstig erwiesen, wenn die negative Vorspannung bei der Keimbildung im Bereich von 60 bis 300 Volt liegt, bevorzugterweise ca. 150 Volt, und ein 0,1- bis 10%iger Prozeßgasstrom von Methan in Wasserstoff zugeführt wird. Ganz besonders vorteilhaft ist ein 0,2- bis 2%iger Prozeßgasstrom.

Die Durchführung der Wachstumsphase erfolgt dann ohne Anlegen einer Bias-Spannung unter an und für sich bekannten Bedingungen. Günstig sind Substrattemperaturen von 400 bis 1100°C und ein 0,1- bis 10%iger Prozeßgasstrom von CH₄ in H₂. Bevorzugt ist auch hier - wie bei der Keimbildung - mit einem 0,2- bis 2%igen Prozeßgasstrom zu arbeiten.

Erfindungsgemäß kann über die Zeitdauer der Keimbildungsphase die gewünschte Keimdichte ausgewählt werden. Die gewünschte Dicke der Diamantschicht läßt sich in Abhängigkeit der Abscheidungsdauer ebenfalls variieren.

Das erfindungsgemäße Verfahren bringt demgemäß gegenüber dem Stand der Technik entscheidende Vorteile mit sich:
1. Durch die erfindungsgemäße Vorbehandlung werden Si-Oberflächen effektiv gereinigt, so daß im zweiten Schritt orientierte Keime auf Silicium erzeugt werden können.
2. Gegenüber den meisten anderen Materialien ist Silicium das Basismaterial für die heutige Mikroelektronik.
   Durch das erfindungsgemäße Verfahren werden somit völlig neue Anwendungsmöglichkeiten erschlossen, und es lassen sich Schichten herstellen, die in ihren elektrischen Eigenschaften perfekten Diamanteinkristallen nahekommen.
3. Das erfindungsgemäße Verfahren erlaubt es, die Oberflächenreinigung der Substrate, die Keimbildung und das Wachstum der Diamantschichten in einem Prozeß durchzuführen.

Die mit dem erfindungsgemäßen Verfahren hergestellten Schichten zeichnen sich dadurch aus, daß die einzelnen Kristallite Kantenabmessungen von 0,1 bis 100 µm aufweisen und zu 20 bis 100 % am Gitter des Si-Substrates ausgerichtet sind. Das Verfahren eignet sich vorzugsweise für (100)-, (111)- oder (110)-orientierte Si-Substrate.

Die Ausrichtung ist dergestalt beschaffen, daß im Rahmen einer möglichen Fehlorientierung von weniger als 10° einander entsprechende Kristallorientierungen <hkl> im Substrat und in den Kristalliten parallel sind.

Dadurch erschließen sich völlig neue Anwendungsmöglichkeiten, wie der Einsatz als wärmeleitende isolierende Schichten (Leistungshalbleiter, Laserdiode etc.) oder als wärmeleitende Schicht mit hohem elektrischen Widerstand und hoher Durchbruchfeldstärke zur Kühlung von Halbleiterbauelementen. Weitere Anwendungsmöglichkeiten sind der Einsatz als optische Fenster mit hoher mechanischer Stabilität und geringer Absorption sowie als aktives Halbleitermaterial im elektronischen Bauelement und als piezoresistiver Sensor und als Thermistor.

Die Erfindung wird nachstehend anhand eines Ausführungsbeispieles näher erläutert. Es zeigen:
- Fig. 1: einen beispielhaften Versuchsaufbau,
- Fig. 2: einen typischen Prozeßverlauf,
- Fig. 3: REM-Aufnahmen der erfindungsgemäß hergestellten Schicht,
- Fig. 4: RAMAN-Spektrum der Oberfläche.

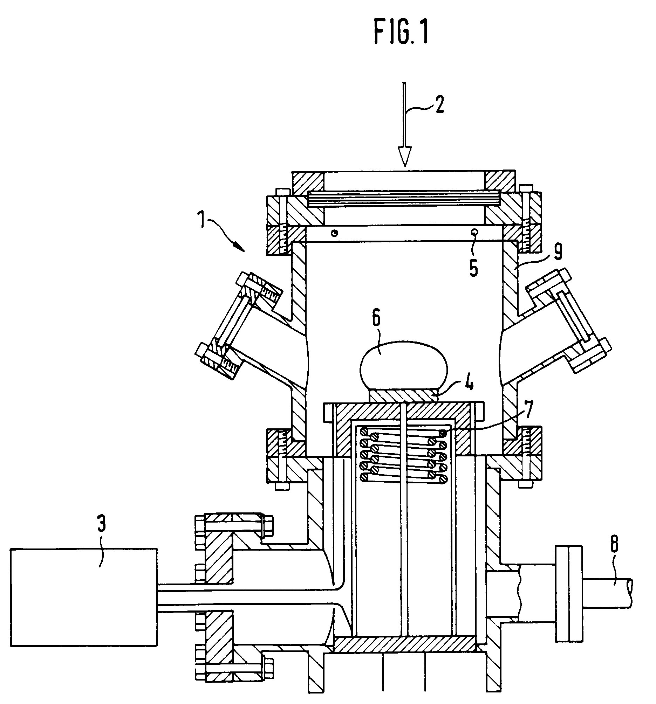

Figur 1 zeigt einen beispielhaften Versuchsaufbau. Im vorliegenden Beispiel wurde eine MWPCVD-Anlage 1 verwendet. Die MWPCVD-Anlage 1 verfügt über einen Mikrowellengenerator mit einstellbarer Mikrowellenleistung bis 1,5 KW zur Erzeugung einer Mikrowelle 2. Erfindungsgemäß ist die MWPCVD-Anlage mit einer Gleichspannungs-Bias-Versorgung 3 versehen. Die Substrat-Bias-Spannungsversorgung 3 ist dabei bis ±300 Volt justierbar.

Bei jedem Versuch wurde ein (100)-Siliciumsubstrat 4 vor dem Depositionsexperiment in einem Aceton-Ultraschallbad gereinigt. Nach der Positionierung des Substrates 4 in Reaktor 1 wurde die Vakuumkammer auf 10⁻² mbar evakuiert und das Substrat aufgeheizt. Anschließend wurden die Prozeßgase über die Gaszuführung 5 zugeführt und das Plasma 6 gezündet. Die Heizung des Reaktors erfolgt dabei über die Heizung 7. Über den Pumpstutzen 8 wird das Vakuum erzeugt. Zur Kühlung ist eine Wasserkühlung 9 vorgesehen.

Erfindungsgemäß läuft das Verfahren zur Herstellung der Schicht nun in drei Schritten ab:
1. Plasmareinigung der Substrat-Oberflächen,
2. Diamantkeimbildung mit Hilfe der Substrat-Bias-Spannung,
3. Diamantwachstum.

In Tabelle 1 sind die Parameter für die drei einzelnen Schritte detailliert aufgeführt. Die Dicke der Diamantschicht wird dabei durch die Abscheidungsdauer kontrolliert. Die Diamantkeimbildung erfolgt je nach der angestrebten Keimdichte in einer Zeitspanne von ca. 2 min bis 200 min.

**Tabelle 1**

| | Plasma-Reinigung | Keimbildung | Diamantabscheidung |
|---|---|---|---|
| H₂ | 100 vol% | 80 - 99 vol% | 95 - 99.8 vol% |
| CH₄ | 0 vol% | 0.5 - 20.0 vol% | 0.2- 5 vol% |
| Temp. | 300 - 1100 °C | 400 - 1000 °C | 400 - 1000 °C |
| Leistung | 500 - 1500 W | 500 - 1500 W | 500 - 1500 W |
| Druck | 10-100 mbar | 10-100 mbar | 10-100 mbar |
| Bias | -50 V | -50 ---- -300V | 0 V |

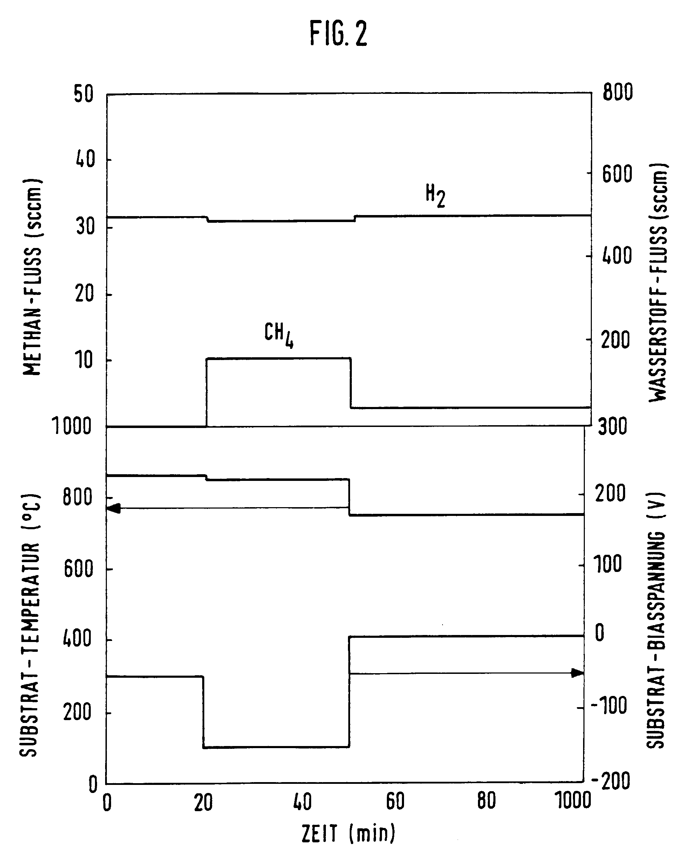

Der typische Prozeßverlauf für das erfindungsgemäße Verfahren mittels der Vorrichtung nach Beispiel 1 ist in Figur 2 wiedergegeben. Figur 2 ist in Form einer Doppelkurve aufgebaut. Der untere Teil zeigt den Verlauf der Substrattemperatur sowie der Substrat-Bias-Spannung während einer Zeitdauer von 0 bis 1000 min.

Im beispielhaften Fall beträgt die Zeitphase für die Plasmareinigung 20 min. Aus der Doppelgrafik ist gut ersichtlich, daß während dieser Zeitspanne die Substrat-Bias-Spannung -50 Volt beträgt und der Methanfluß 0 ist, wohingegen der Wasserstofffluß ca. 500 sccm beträgt. Da während dieser Zeitphase der Methanfluß 0 ist, liegt ein 100 %iger Volumenanteil von Wasserstoff vor.

Im Anschluß daran wird die negative Bias-Spannung auf -150 Volt erhöht, gleichzeitig wird ein Methanfluß von ca. 200 sccm eingestellt und der Wasserstofffluß geringfügig reduziert, so daß sich ein Volumenanteil von Wasserstoff in der Größenordnung von 80 bis 99 Vol.% und ein Volumenanteil Methan in der Größenordnung von 0,5 bis 20 Vol.% einstellt. Die Substrattemperatur wird entsprechend eingestellt.

Nach Abschluß dieser 30-minütigen Keimbildungsphase beginnt der Zeitabschnitt der Diamantabscheidung. Die Bias-Spannung wird dabei vom Substrat genommen und beträgt ab diesem Zeitpunkt somit 0. Gleichzeitig wird der Wasserstoffvolumenstrom zurückgenommen, um ein kontinuierliches Aufwachsen der Schicht zu erreichen.

Die Schichten werden durch Röntgenbeugung, Pol-Figur-Analyse und REM charakterisiert. Die Ergebnisse zeigen, daß die Schichten aus einer Diamantphase bestehen.

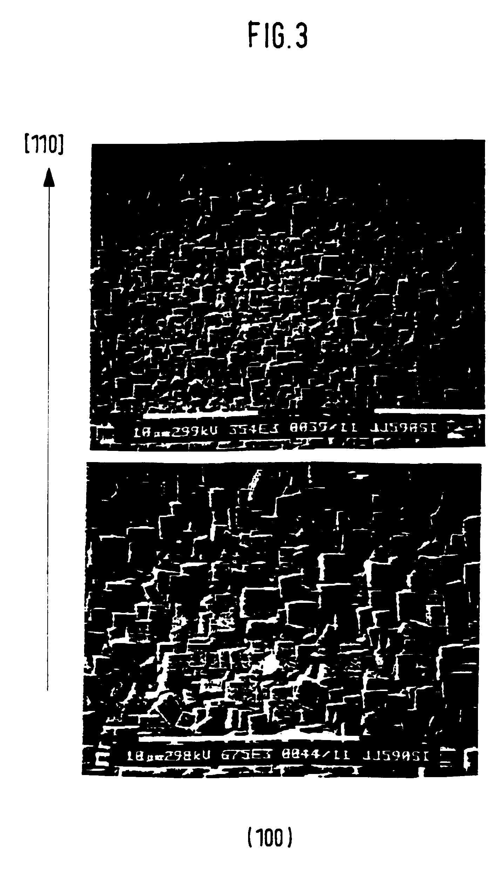

Figur 3 zeigt zwei REM-Aufnahmen einer erfindungsgemäß hergestellten Schicht nach einer Abscheidungsdauer von 20 Stunden. Aus den REM-Aufnahmen ist klar ersichtlich, daß 80 bis 90 % der Kristalle orientiert sind. Durch Pol-Figur-Analyse wurde festgestellt, daß die Diamantkristalle folgende Beziehungen zum Substrat haben:
(001) Diamant || (001)Silicium
[011)Diamant || [011]Silicium.

Durch Röntgenbeugung konnten nur Reflexe von Diamant und Silicium nachgewiesen werden.

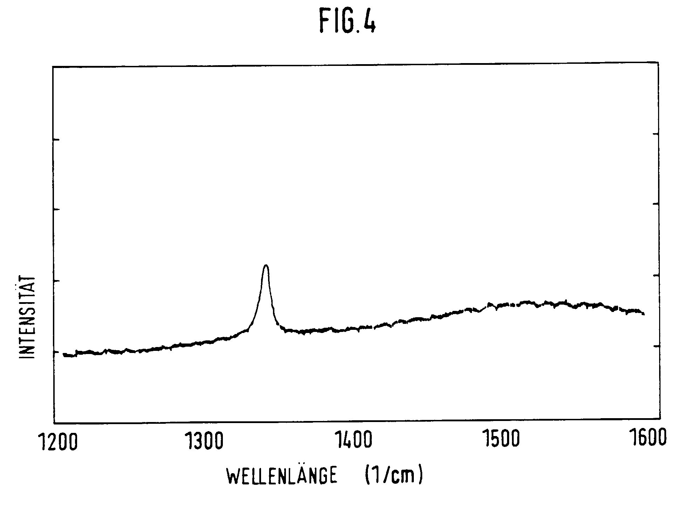

Figur 4 zeigt ein RAMAN-Spektrum der Schicht. Bei 1335 cm⁻¹ ist die Diamantlinie deutlich sichtbar.

Mit dem erfindungsgemäßen Verfahren können somit heteroepitaktische Diamantschichten auf Silicium abgeschieden werden. Damit wird ein weites Feld von Anwendungsmöglichkeiten erschlossen.

## Patentansprüche

1. Verfahren zur Herstellung heteroepitaktischer Diamantschichten auf Si-Substraten mittels CVD, wobei in einem mit einem erhitzten Si-Substrat versehenen Reaktor übliche Prozeßgase zugeführt werden,
**gekennzeichnet** durch die Kombination der folgenden Verfahrensschritte:
(a) Vorbehandlung der Si-Oberfläche durch Anlegen eines Vakuums und Erhitzen des Si-Substrates auf Temperaturen zwischen 300 und 1100° C;
(b) Durchführung einer Keimbildungsphase unter Anlegung einer Bias-Spannung im Bereich von -60 bis -300 Volt bei einer Substrattemperatur von 400 bis 1100° C;
(c) Durchführung der Diamantabscheidung unter an und für sich bekannten Bedingungen ohne Anlegung einer Bias-Spannung.

2. Verfahren nach Anspruch 1,
dadurch gekennzeichnet, daß die Vorbehandlung im Ultrahochvakuum bei < 10⁻⁹ mbar und bei einer Temperatur größer als 950° C durchgeführt wird.

3. Verfahren nach Anspruch 1,
dadurch gekennzeichnet, daß die Vorbehandlung eine Plasmareinigung mit Wasserstoff mit einem Wasserstoffanteil größer als 95% ist, wobei die Substrattemperatur im Bereich von 600 bis 1100° C liegt.

4. Verfahren nach Anspruch 3,
dadurch gekennzeichnet, daß die Plasmareinigung unter gleichzeitiger Anlegung einer Bias-Spannung von +50 bis -300 Volt erfolgt.

5. Verfahren nach Anspruch 4,
dadurch gekennzeichnet, daß die Bias-Spannung ca. -50 Volt ist.

6. Verfahren nach mindestens einem der Ansprüche 1 bis 5,
dadurch gekennzeichnet, daß das Prozeßgas CH₄/H₂ ist.

7. Verfahren nach Anspruch 6,
dadurch gekennzeichnet, daß während der Keimbildungsphase (Verfahrensschritt b) die negative Bias-Spannung ca. 150 Volt beträgt und ein 0,1- bis 10%iger Prozeßgasstrom von Methan in Wasserstoff eingesetzt wird.

8. Verfahren nach mindestens einem der Ansprüche 6 oder 7,
dadurch gekennzeichnet, daß während der Diamantabscheidung (Verfahrensschritt c) die Temperatur des Si-Substrates im Bereich von 400 bis 1100° C liegt und eine 0,1- bis 10%iger Prozeßgasstrom von Methan in Wasserstoff eingesetzt wird.

9. Verfahren nach mindestens einem der Ansprüche 1 bis 8,
dadurch gekennzeichnet, daß die Zeitdauer der Keimbildungsphase in Abhängigkeit der gewünschten Keimdichte ausgewählt wird.

10. Verfahrens nach mindestens einem der Ansprüche 1 bis 9,
dadurch gekennzeichnet, daß die gewünschte Dicke der Diamantschicht in Abhängigkeit der Abscheidungsdauer ausgewählt wird.

11. Heteroepitaktische Diamantschicht, hergestellt nach mindestens einem der Verfahrensansprüche 1 bis 10,
dadurch gekennzeichnet, daß die einzelnen Kristallite mit Kantenabmessungen von 0,1 bis 100 µm zu mehr als 20 bis 100% am Gitter des Si-Substrates ausgerichtet sind.

12. Heteroepitaktische Diamantschicht nach Anspruch 11,
dadurch gekennzeichnet, daß die Ausrichtung der Kristallite so beschaffen ist, daß im Rahmen einer möglichen Fehlorientierung von weniger als 10° einander entsprechende Kristallorientierungen (hkl) im Substrat und in den Kristalliten parallel sind.

13. Verwendung der heteroepitaktischen Diamantschicht nach Anspruch 11 bis 12 als wärmeleitende elektrisch isolierende Schicht.

14. Verwendung der heteroepitaktischen Diamantschicht nach Anspruch 11 bis 12 als Material für optische Fenster mit hoher mechanischer Stabilität, geringer Absorption und guter thermischer Beständigkeit.

15. Verwendung der heteroepitaktischen Diamantschicht nach Anspruch 11 bis 12 als aktives Halbleitermaterial in einem elektronischen Bauelement.

16. Verwendung der heteroepitaktischen Diamantschicht nach Anspruch 11 bis 12 als piezoresistiver Sensor.

17. Verwendung der heteroepitaktischen Diamantschicht nach Anspruch 11 bis 12 als Thermistor.

## Claims

1. Process for producing heteroepitaxial diamond layers on Si substrates by means of CVD, which involves supplying conventional process gases in a reactor provided with a heated Si substrate, characterized by the combination of the following process steps:
(a) pretreatment of the Si surface by applying a vacuum and heating the Si substrate to temperatures of between 300 and 1100°C;
(b) performing a nucleation phase while applying a bias voltage in the range of from -60 to -300 volts at a substrate temperature of from 400 to 1100°C;
(c) performing the deposition of diamond under conditions known per se without applying a bias voltage.

2. Process according to Claim 1, characterized in that the pretreatment is carried out in an ultra-high vacuum at < 10⁻⁹ mbar and at a temperature above 950°C.

3. Process according to Claim 1, characterized in that the pretreatment is a plasma cleaning step with hydrogen having a hydrogen proportion above 95%, the substrate temperature being in the range of from 600 to 1100°C.

4. Process according to Claim 3, characterized in that the plasma cleaning step is carried out while a bias voltage of from +50 to -300 volts is applied at the same time.

5. Process according to Claim 4, characterized in that the bias voltage is about -50 volts.

6. Process according to at least one of Claims 1 to 5, characterized in that the process gas is CH₄/H₂.

7. Process according to Claim 6, characterized in that, during the nucleation phase (process step b), the negative bias voltage is about 150 volts and a process gas stream is employed which contains from 0.1 to 10% of methane in hydrogen.

8. Process according to at least one of Claims 6 and 7, characterized in that, during the diamond deposition (process step c), the temperature of the Si substrate is in the range of from 400 to 1100°C and a process gas stream is employed which contains from 0.1 to 10% of methane in hydrogen.

9. Process according to at least one of Claims 1 to 8, characterized in that the duration of the nucleation phase is selected as a function of the desired nucleus density.

10. Process according to at least one of Claims 1 to 9, characterized in that the desired thickness of the diamond layer is selected as a function of the deposition period.

11. Heteroepitaxial diamond layer, produced according to at least one of process Claims 1 to 10, characterized in that the individual crystallites having edge dimensions of from 0.1 to 100 µm are aligned, to an extent of more than 20 up to 100%, with respect to the lattice of the Si substrate.

12. Heteroepitaxial diamond layer according to Claim 11, characterized in that the alignment of the crystallites is such that, within the context of possible misalignment of less than 10°, crystal orientations (hkl) corresponding to one another are parallel in the substrate and in the crystallites.

13. Use of the heteroepitaxial diamond layer according to Claim 11 to 12 as a heat-conducting, electrically insulating layer.

14. Use of the heteroepitaxial diamond layer according to Claim 11 to 12 as a material for optical windows having high mechanical stability, low absorption and good thermal stability.

15. Use of the heteroepitaxial diamond layer according to Claim 11 to 12 as an active semiconductor material in an electronic component.

16. Use of the heteroepitaxial diamond layer according to Claim 11 to 12 as a piezoresistive sensor.

17. Use of the heteroepitaxial diamond layer according to Claim 11 to 12 as a thermistor.

## Revendications

1. Procédé de fabrication de couches de diamant par hétéroépitaxie au moyen de la CVD sur des substrats en Si, des gaz de traitement usuels étant introduits dans un réacteur où on a placé un substrat chauffé en Si,
caractérisé par la combinaison des étapes de procédé suivantes :
(a) Prétraitement de la surface du Si par établissement d'un vide et chauffage du substrat de Si à des températures comprises entre 300 et 1100°C;
(b) Mise en oeuvre d'une phase de nucléation en établissant une tension de polarisation d'environ -60 à -300 Volt à une température de substrat de 400 à 1100°C;
(c) Réalisation du dépôt de diamant dans des conditions connues en et pour elles mêmes sans application d'une tension de polarisation.

2. Procédé selon la revendication 1, caractérisé en ce que le prétraitement est effectué sous ultravide < 10⁻⁹ mbar et à une température supérieure à 950°C.

3. Procédé selon la revendication 1, caractérisé en ce que le prétraitement est un nettoyage par plasma d'hydrogène avec un titre en hydrogène supérieur à 95%, la température du substrat étant comprise entre 600 et 1100°C.

4. Procédé selon la revendication 3, caractérisé en ce que le nettoyage par plasma est effectué en établissant en même temps une tension de polarisation comprise entre +50 et -300 Volt.

5. Procédé selon la revendication 4, caractérisé en ce que la tension de polarisation est d'environ -50 Volt.

6. Procédé selon au moins une des revendications 1 à 5, caractérisé en ce que le gaz de traitement est un mélange CH₄/H₂.

7. Procédé selon la revendication 6, caractérisé en ce que pendant la phase de germination (étape b du procédé), la tension de polarisation négative est d'environ 150 Volt et en ce qu'on utilise un flux de gaz de traitement de 0,1 à 10% de méthane dans l'hydrogène.

8. Procédé selon au moins une des revendications 6 ou 7, caractérisé en ce que pendant le dépôt de diamant (étape c du procédé), la température du substrat de Si est située dans la gamme comprise entre 400 et 1100°C et en ce qu'on utilise un flux de gaz de traitement de 0,1 à 10% de méthane dans l'hydrogène.

9. Procédé selon au moins une des revendications 1 à 8, caractérisé en ce que l'on choisit la durée de la phase de germination en fonction de la densité de germes souhaitée.

10. Procédé selon au moins une des revendications 1 à 9, caractérisé en ce que l'on choisit la durée de la phase de dépôt en fonction de l'épaisseur de la couche de diamant souhaitée.

11. Couche de diamant hétéroépitaxiale préparée selon au moins une des revendications de procédé 1 à 10, caractérisée en ce que les cristallites élémentaires avec des dimensions d'arêtes de 0,1 à 100 µm sont orientées de plus de 20 à 100% sur le réseau du substrat de Si.

12. Couche de diamant hétéroépitaxiale selon la revendication 11, caractérisée en ce que l'orientation des cristallites est réalisée de telle sorte que, dans le cadre d'un possible défaut d'orientation de moins de 10°, les orientations des cristaux (hkl) correspondants dans le substrat et dans les cristallites sont parallèles entre eux.

13. Utilisation de la couche de diamant hétéroépitaxiale selon les revendications 11 à 12 comme couche conductrice de la chaleur électriquement isolante.

14. Utilisation de la couche de diamant hétéroépitaxiale selon les revendications 11 à 12 comme matériau pour fenêtres optiques avec une stabilité mécanique élevée, une faible absorption et une bonne stabilité thermique.

15. Utilisation de la couche de diamant hétéroépitaxiale selon les revendications 11 à 12 comme matériau semi-conducteur actif dans un composant électronique.

16. Utilisation de la couche de diamant hétéroépitaxiale selon les revendications 11 à 12 comme capteur piézo-résistif.

17. Utilisation de la couche de diamant hétéroépitaxiale selon les revendications 11 à 12 comme thermistance.
